(19) Europäisches Patentamt

European Patent Office

Office européen des brevets

(11) **EP 0 768 536 B1**

(12) **FASCICULE DE BREVET EUROPEEN**

(45) Date de publication et mention
de la délivrance du brevet:
**15.10.2003 Bulletin 2003/42**

(51) Int Cl.⁷: **G01R 31/06**

(21) Numéro de dépôt: **96112449.2**

(22) Date de dépôt: **01.08.1996**

(54) **Procédé de détermination du courant moyen circulant dans une charge inductive**

Verfahren zum Bestimmen des mittleren Stroms in einer induktiven Last

Process for determining the mean current in an inductive load

(84) Etats contractants désignés:
**DE ES GB IT**

(30) Priorité: **13.10.1995 FR 9512125**

(43) Date de publication de la demande:
**16.04.1997 Bulletin 1997/16**

(73) Titulaire: **Siemens VDO Automotive S.A.S.
31036 Toulouse Cédex 01 (FR)**

(72) Inventeurs:
• **Avian, Philippe**
  **78300 Poissy (FR)**
• **Hannoyer, Gilles**
  **31320 Castanet (FR)**
• **Lucchese, Alain**
  **31320 Vigoulet Auzil (FR)**

(74) Mandataire: **Berg, Peter, Dipl.-Ing. et al
European Patent Attorney,
Siemens AG,
Postfach 22 16 34
80506 München (DE)**

(56) Documents cités:
**DE-A- 4 122 348       FR-A- 2 639 680
US-A- 4 897 794**

EP 0 768 536 B1

**Description**

La présente invention est relative à un procédé de détermination du courant moyen circulant dans une charge inductive, comme par exemple l'enroulement d'excitation d'une électrovanne.

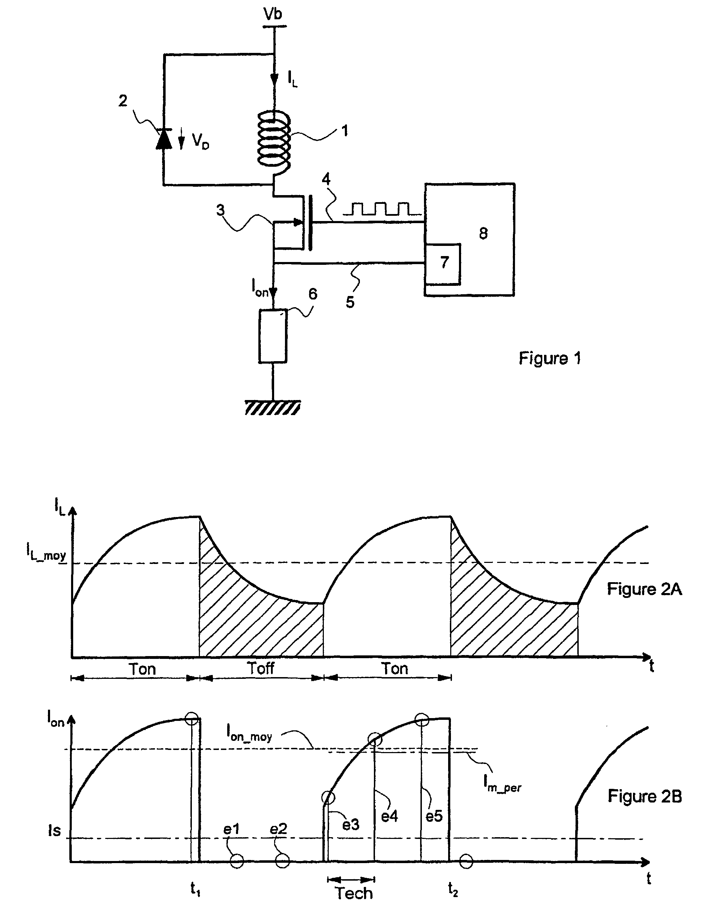

Dans de nombreux processus de commande, certains paramètres sont réglés par des actionneurs électromagnétiques tels des électrovannes. On peut citer, à titre d'exemple, la régulation de ralenti d'un moteur à combustion interne, où une quantité d'air additionnel est dosée par une électrovanne normalement fermée par un ressort, et dont le degré d'ouverture est commandé par un courant variable circulant dans son enroulement d'excitation. Un dispositif de ce type est représenté schématiquement sur la figure 1, où l'enroulement de l'électrovanne est symbolisé par une charge inductive 1, connectée d'une part à une source de tension d'alimentation Vb et d'autre part à un commutateur 3, figuré par un transistor. Ce commutateur est commandé sur son entrée de commande 4 par un signal rectangulaire périodique de fréquence fixe et de rapport cyclique variable. La borne du commutateur 3 opposée à la charge inductive est reliée à la masse par l'intermédiaire d'une résistance 6. Une ligne 5 connectée entre le commutateur et la résistance permet de mesurer le courant qui traverse le commutateur au moyen d'un convertisseur analogique / digital 7 formant partie d'un microprocesseur 8. Bien entendu, cette résistance n'est qu'un exemple de moyen de mesure du courant, certains commutateurs modernes comportant des dispositifs intégrés propres à donner le même résultat. Lorsque le commutateur interrompt le passage du courant vers la masse, l'énergie accumulée dans la charge inductive recircule sous la forme d'un courant traversant dans le sens passant une diode 2 montée en parallèle sur la charge 1, sous une tension $V_D$ prédéterminée dépendant du type de diode utilisée. Pour connaître le degré d'ouverture de la vanne, et pour le commander par action sur le rapport cyclique de commande, il est nécessaire de connaître le courant moyen qui circule dans la charge inductive. Or, s'il est aisé de mesurer ce courant lorsque le commutateur est fermé, il n'est pas possible de mesurer le courant qui recircule par l'intermédiaire de la diode 2 lorsque le circuit est interrompu par l'ouverture du commutateur, d'autant plus que ce courant dépend de nombreux paramètres, tels que la température de l'enroulement qui influe sur l'inductance et la résistance de la charge 1 et donc sur l'énergie stockée dans celle-ci. De plus, pour un actionneur électromagnétique, le rapport cyclique de commande modifie la configuration du circuit magnétique (entrefer) et donc l'inductance de la charge.

On connaît de la technique antérieure, par exemple de la demande de brevet français n° 2 696 253, un procédé selon lequel on augmente la durée de conduction du commutateur afin de permettre au courant circulant dans la charge d'atteindre le courant de saturation et d'en déduire la résistance actuelle de la charge. Cependant, un tel procédé présente l'inconvénient de modifier la durée d'excitation de l'électrovanne donc son degré d'ouverture et peut avoir une influence néfaste sur le respect d'une consigne de ralenti du moteur.

On connaît également, par exemple de la demande de brevet français n° 2 639 680 des dispositifs qui utilisent la valeur maximale du courant atteinte au moment de l'interruption du circuit pour en déduire le courant moyen qui circule dans la charge. Cependant, cette valeur maximale doit être mesurée par l'intermédiaire de dispositifs analogiques tels qu'un échantillonneur-bloqueur qui représentent un coût supplémentaire, et la valeur du courant moyen est sujette à des erreurs importantes du fait des bruits affectant la mesure de la valeur crête. De plus, les fluctuations de la résistance de la charge avec la température doivent être compensées par des algorithmes de traitement complexes.

La présente invention a donc pour but de proposer un procédé de détermination du courant moyen circulant dans une charge inductive qui ne présente pas ces inconvénients.

On atteint ces buts de l'invention, ainsi que d'autres qui apparaîtront dans la suite de la présente description, au moyen d'un procédé de détermination du courant moyen circulant dans une charge inductive, connectée entre une source d'alimentation délivrant une tension Vb et un commutateur apte, de façon périodique et avec un rapport cyclique de commande RCO donné, soit à conduire le courant vers un potentiel de masse, soit à interrompre cette conduction, une diode étant adaptée pour permettre à l'énergie stockée dans la charge inductive de recirculer vers le potentiel Vb, ledit procédé utilisant la mesure du courant circulant dans le commutateur, selon lequel on échantillonne, de manière asynchrone au rapport cyclique de commande, et avec une fréquence supérieure à celui-ci, le courant qui circule dans le commutateur, on élimine les échantillons dont la valeur est inférieure à un seuil prédéterminé, on effectue, en synchronisme avec l'interruption de la conduction, la moyenne des échantillons retenus pour obtenir une valeur moyenne du courant circulant dans le commutateur pendant la conduction de celui-ci, et on calcule la valeur du courant moyen circulant dans la charge à partir de la valeur moyenne du courant circulant dans le commutateur, de la tension d'alimentation, de l'inductance et de la résistance nominales de la charge inductive, du rapport cyclique de commande RCO, et de la tension directe de la diode.

Suivant une caractéristique importante de la présente invention, la valeur moyenne du courant circulant dans le commutateur est obtenue en effectuant une moyenne intermédiaire des échantillons retenus pendant la dernière période de commande et en filtrant par une moyenne pondérée de cette moyenne intermédiaire et de la valeur moyenne du courant circulant dans le commutateur obtenue à la période de commande précédente.

Suivant un mode de mise en oeuvre du procédé selon l'invention, on calcule la valeur du courant moyen circulant dans la charge à partir de la formule:

$$I_{L\_moy} = I_{on\_moy} - (Vb + V_D) \times Tab(RCO)$$

où Tab(RCO) est une table définie en fonction du rapport cyclique de commande déterminée lors d'une étape préalable de mise au point.

D'autres caractéristiques et avantages du procédé suivant l'invention apparaîtront à la lecture de la description qui va suivre et à l'examen des dessins annexés dans lesquels:

- la figure 1 représente le circuit de commande de la charge inductive décrit dans le préambule, et
- la figure 2A représente un graphe temporel du courant circulant dans la charge alors que la figure 2B représente celui du courant mesurable sur la ligne 5 du circuit de la figure 1.

On se réfère à la figure 2A sur laquelle on a représenté le courant $I_L$ circulant dans la charge inductive 1 lorsque le commutateur 3 est actionné par un signal de commande rectangulaire de période fixe et de rapport cyclique RCO variable. Le rapport cyclique RCO est exprimé par le rapport Ton / (Ton+Toff) où Ton est la durée pendant laquelle le commutateur 3 est conducteur, Toff la durée pendant laquelle le commutateur 3 est non conducteur, la somme Ton+Toff représentant la période du signal de commande. Le problème que vise à résoudre l'invention est celui de la détermination du courant moyen $I_{L\_moy}$ dans la charge inductive. Comme on peut le constater sur la figure 2B, le courant mesurable avec un dispositif tel que celui de la figure 1 est le courant $I_{on}$ qui traverse le commutateur 3, qui est égal au courant IL pendant la durée Ton et nul pendant Toff. De ce fait, le courant $I_L$ circulant dans la charge pendant la durée Toff, ainsi que sa valeur moyenne représentée par la zone hachurée sur la figure 2A ne sont pas directement mesurables.

Selon l'invention, on échantillonne, au moyen de mesures effectuées par le convertisseur analogique-digital 7, des valeurs successives du courant Ion. Cet échantillonnage est effectué avec une période Tech inférieure à la période du signal de commande du commutateur 3, et de manière asynchrone à celui-ci. On choisit en pratique des fréquences d'échantillonnage de 3 à 10 fois supérieures à la fréquence du signal de commande, en évitant les multiples entiers afin de permettre de prélever des échantillons qui ne sont pas toujours au même endroit de la courbe du courant Ion, avantage que l'on détaillera dans la suite de la description. A titre d'exemple, pour un signal de commande de période Ton+Toff égale à 6,25 millisecondes, on a choisi une période d'échantillonnage de 1 milliseconde. Un tel échantillonnage est avantageux car les microprocesseurs modernes permettent de réaliser cette fonction en tâche de fond, ce qui permet d'économiser les ressources du microprocesseur pour d'autres tâches, celui-ci n'ayant pas besoin de synchroniser ses mesures avec le signal de commande, comme c'est le cas dans la technique antérieure lorsqu'on veut mesurer la valeur crête du courant en présence d'un rapport cyclique variable. Sur la figure 2B, on a ainsi noté e1 à e5 les échantillons mesurés entre les instants t1 et t2 correspondant à une période du signal de commande. Ces échantillons sont, à mesure de leur obtention, comparés à un seuil Is, proche de zéro, afin d'éliminer les échantillons correspondant à la durée Toff du commutateur. Bien entendu, cette élimination aurait pu être effectuée au prix d'une synchronisation supplémentaire, en ne conservant que les échantillons obtenus pendant la durée Ton. A l'instant t2, lors de l'interruption de la conduction du commutateur 3, le microprocesseur 8 calcule la moyenne des échantillons retenus (ici, e3 à e5) pour obtenir une valeur intermédiaire $I_{m\_per}$ représentant la valeur moyenne du courant $I_{on}$ pendant la dernière durée de conduction. Cette valeur intermédiaire $I_{m\_per}$ est ensuite utilisée dans un filtre récursif de type moyenne pondérée pour obtenir une valeur $I_{on\_moy}$ représentant la valeur moyenne du courant $I_{on}$ pendant la conduction du commutateur 3. On peut par exemple utiliser une formule du type:

$$I_{on\_moy}(i) = (1 - k) \times I_{on\_moy}(i-1) + k \times I_{m\_per}$$

où k représente un facteur de pondération permettant de régler la constante de temps du filtre et i la période considérée du signal de commande. On remarquera que, avantageusement, l'emploi d'une valeur moyenne intermédiaire permet une mise à jour de la valeur moyenne $I_{on\_moy}$ du courant à chaque période, de façon indépendante du rapport cyclique.

On en vient maintenant au calcul du courant moyen $I_{L\_moy}$ circulant dans la charge inductive 1. Si l'étude théorique du circuit de la figure 1 permet de calculer ce courant moyen dans des conditions idéales, en fonction des paramètres Vb (tension d'alimentation du circuit), $V_D$ (tension directe de la diode de recirculation), RCO (rapport cyclique de commande) et en fonction également de l'inductance et de la résistance réelles de la charge, on constate néanmoins que le résultat de ce calcul s'écarte de la réalité obtenue dans les conditions pratiques. En particulier, dans le cas réel, les valeurs de l'inductance et de la résistance de la charge ne sont pas connues de manière exacte, du fait d'une part des dispersions de ces valeurs à l'origine, liées aux tolérances de fabrication, et d'autre part de leur variation en fonction de la température. De plus, pour un actionneur électromagnétique, le rapport cyclique de commande modifie la configuration du circuit magnétique (entrefer) et donc l'inductance de la charge. L'erreur ainsi introduite peut être avantageusement compensée en utilisant le courant moyen $I_{on\_moy}$ circulant dans l'interrupteur pendant les phases de conduction, tel qu'il a été obtenu précédemment. En effet, en effectuant un échantillonnage du courant $I_{on}$ asynchrone par rapport à la période de commande de l'interrupteur, on obtient des valeurs de ce courant qui décrivent la courbe de variation de celui-ci. Le courant moyen ainsi obtenu tient donc compte de la forme de cette courbe qui est directement reliée aux paramètres résistance et inductance réels de la charge. On a pu ainsi établir, à partir de calculs et d'expérimentations de mise au point, la formule suivante permettant d'obtenir le courant moyen dans la charge inductive:

$$I_{L\_moy} = I_{on\_moy} - \left[ (Vb + V_D) \times R^{0.8} \times \frac{Ton \times Toff}{11 \times L^{1.8} \times (Ton + Toff)} \right]$$

où R et L sont respectivement la résistance et l'inductance nominales de la charge. On conçoit aisément qu'une telle formule est complexe à intégrer dans un calculateur du type de ceux qui équipent un véhicule automobile, et serait coûteuse en temps de calcul. On propose donc de tirer avantage du fait que les valeurs de R et L sont constantes pour former, lors de la mise au point, une table de valeurs en fonction du rapport cyclique de commande Tab(RCO), table qui est classiquement exploitée par interpolation. L'emploi d'une telle table présente, outre le gain en vitesse de calcul, l'intérêt de pouvoir corriger certaines imperfections ponctuelles de l'algorithme, par exemple pour des rapports cycliques très faibles. On calcule alors la valeur du courant moyen circulant dans la charge inductive 1 par la formule:

$$I_{L\_moy} = I_{on\_moy} - (Vb + V_D) \times Tab(RCO)$$

On a ainsi montré un procédé de détermination du courant moyen circulant dans une charge inductive capable de compenser les variations des paramètres de la charge (résistance et inductance), sans nécessiter pour cela de modification de la commande de l'interrupteur ou de circuits additionnels de mise en forme du courant, et qui présente en outre l'avantage d'être plus robuste vis à vis du bruit et des parasites pouvant affecter les mesures du courant grâce à l'utilisation du courant moyen circulant dans l'interrupteur obtenu par échantillonnage, moyenne et filtrage de la valeur instantanée de ce courant.
Bien entendu, l'invention n'est pas limitée à l'emploi d'un tel procédé dans le cadre d'une vanne d'air additionnel pour la régulation de ralenti des moteurs à combustion interne, mais peut être utilisée dans tous les cas où la connaissance du courant moyen circulant dans une charge inductive peut être utile. L'invention est limitée par les revendications.

**Revendications**

1. Procédé de détermination du courant moyen circulant dans une charge inductive (1), connectée entre une source d'alimentation délivrant une tension Vb et un commutateur (3) apte, de façon périodique et avec un rapport cyclique de commande RCO donné, soit à conduire le courant vers un potentiel de masse, soit à interrompre cette conduction, une diode (2) étant adaptée pour permettre à l'énergie stockée dans la charge inductive de recirculer vers le potentiel Vb, ledit procédé utilisant la mesure du courant (Ion) circulant dans le commutateur, **caractérisé en ce que** :

   • on échantillonne, de manière asynchrone au rapport cyclique de commande, et avec une période inférieure à celui-ci, le courant ($I_{on}$) qui circule dans le commutateur,
   • on élimine les échantillons dont la valeur est inférieure à un seuil (Is) prédéterminé,
   • on effectue, en synchronisme avec l'interruption de la conduction, la moyenne des échantillons retenus pour obtenir une valeur moyenne ($I_{on\_moy}$) du courant circulant dans le commutateur pendant la conduction de celui-ci,
   • on calcule la valeur du courant moyen ($I_{L\_moy}$) circulant dans la charge à partir de la valeur moyenne ($I_{on\_moy}$) du courant circulant dans le commutateur, de la tension d'alimentation (Vb), de l'inductance (L) et de la résistance (R) nominales de la charge inductive, du rapport cyclique de commande RCO, et de la tension directe ($V_D$) de la diode.

2. Procédé selon la revendication 1, **caractérisé en ce que** la valeur moyenne ($I_{on\_moy}$) du courant circulant dans le commutateur est obtenue en effectuant une moyenne intermédiaire ($I_{m\_per}$) des échantillons retenus pendant la dernière période de commande et en filtrant par une moyenne pondérée de cette moyenne intermédiaire et de la valeur moyenne du courant circulant dans le commutateur obtenue à la période de commande précédente.

**3.** Procédé selon la revendication 1, **caractérisé en ce que** l'on calcule la valeur du courant moyen ($I_{L\_moy}$) circulant dans la charge à partir de la formule:

$$I_{L\_moy} = I_{on\_moy} - (Vb + V_D) \times Tab(RCO)$$

où Tab(RCO) est une valeur extraite d'une table définie en fonction du rapport cyclique de commande RCO déterminée lors d'une étape préalable de mise au point.

**Patentansprüche**

**1.** Verfahren zum Bestimmen des mittleren Stromes in einer induktiven Last (1), die zwischen eine eine Spannung Vb liefernde Versorgungsquelle und einen Schalter (3) geschaltet ist, der in der Lage ist, periodisch und mit einem vorgegebenen Steuertastverhältnis RCO entweder eine Stromleitung zu einem Massepotential zu ermöglichen oder zu unterbrechen, wobei eine Diode (2) dazu dient, eine Rückführung der in der Last gespeicherten Energie zum Potential Vb zu ermöglichen, wobei das Verfahren eine Messung des in dem Schalter fließenden Stromes (Ion) verwendet, **dadurch gekennzeichnet, dass**:

- der Strom ($I_{on}$), der in dem Schalter fließt, zur Bildung von Messwerten asynchron bezüglich des Steuertastverhältnisses und mit einer kleineren Periode als diesem gemessen wird,
- die Messwerte, deren Wert kleiner als eine vorgegebene Schwelle (Is) ist, eliminiert werden,
- der Mittelwert der beibehaltenen Messwerte synchron zur Unterbrechung der Stromleitung gebildet wird, um einen mittleren Wert ($I_{on\_moy}$) des Stromes, der im Schalter während seines leitenden Zustandes fließt, zu bilden,
- der Wert des in der Last fließenden mittleren Stroms ($I_{L\_moy}$) ausgehend von dem mittleren Wert ($I_{on\_moy}$) des im Schalter fließenden Stroms, der Versorgungsspannung (Vb), der Nenn-Induktanz (L) und dem Nenn-Widerstand (R) der induktiven Last, dem Steuertastverhältnis RCO und der Durchlassspannung ($V_D$) der Diode berechnet wird.

**2.** Verfahren nach Anspruch 1, **dadurch gekennzeichnet, dass** der mittlere Wert ($I_{on\_moy}$) des im Schalter fließenden Stromes in der Weise ermittelt wird, dass ein intermediärer Mittelwert ($I_{m\_per}$) der beibehaltenen Messwerte während der letzten Steuerperiode gebildet und durch einen gewichteten Mittelwert dieses intermediären Mittelwertes und des mittleren Wertes des im Schalter fließenden Stromes, der in der vorhergehenden Steuerperiode erhalten wurde, gefiltert wird.

**3.** Verfahren nach Anspruch 1, **dadurch gekennzeichnet, dass** der Wert des in der Last fließenden mittleren Stromes ($I_{L\_moy}$) aus der folgenden Formel berechnet wird:

$$I_{L\_moy} = I_{on\_moy} - (Vb + V_D) \times Tab(RCO)$$

worin Tab(RCO) ein einer Tabelle entnommener Wert ist, der in Abhängigkeit von dem Steuertastverhältnis RCO definiert ist und während eines vorausgehenden Schrittes des Verfahrens bestimmt wurde.

**Claims**

**1.** Method for determining the average current flowing through an inductive load (1), connected between a power source yielding a voltage Vb and a switch (3) that is capable, periodically and with a given control duty ratio RCO, of either conducting the current to an earth potential or breaking this conduction, a diode (2) being designed to allow the energy stored in the inductive load to flow towards the potential Vb, said method using the measurement of current ($I_{on}$) flowing through the switch, **characterised in that**:

- the current ($I_{on}$) flowing through the switch is sampled, asynchronously with the control duty rate and at shorter periods than it,

- samples that fall below a predetermined threshold (Is) are eliminated,

- the average value of the samples retained is calculated, in synchronisation with the interruption of the conduction, in order to obtain an average value ($I_{on\_moy}$) of the current flowing through the switch while it is conducting,

- the average current ($I_{L\_moy}$) flowing through the load is now calculated from the average current ($I_{on\_moy}$) flowing through the switch, the power supply voltage (Vb), the nominal inductance (L) and nominal resistance (R) of the inductive load, the control duty ratio (RCO) and the forward voltage ($V_D$) of the diode,

2. Method according to Claim 1, **characterised in that** the average value ($I_{on\_moy}$) of the current flowing through the switch is obtained by calculating a provisional average ($I_{m\_per}$) from the samples retained during the last control period and filtering by means of a weighted average of this provisional average and the average value of the current flowing through the switch obtained during the previous control period.

3. Method according to Claim 1, **characterised in that** the average value ($I_{L\_moy}$) of the current flowing through the load is calculated using the formula:

$$I_{L\_moy} = I_{on\_moy} - (Vb + V_D) \times Tab(RCO)$$

where Tab(RCO) is a value taken from a table defined as a function of the control duty cycle RCO determined during a previous tuning phase.

EP 0 768 536 B1

Figure 1

Figure 2A

Figure 2B